# EUROPEAN PATENT APPLICATION

(11) **EP 2 256 835 A2**
(43) Date of publication of application: **01.12.2010**
(21) Application number: 10163313.9
(22) Date of filing: 19.05.2010
(51) Int. Cl.: H01L 41/04

(54) **High gain miniature power supply for plasma generation**

(30) Priority: 27.05.2009 US 472556
(71) Applicant: Lockheed Martin Corporation (Maryland Corp.), Bethesda MD 20817 (US)
(72) Inventor: Tao, Fenfeng, Clifton Park, NV 12065 (US); Bennett, Grover, Rotterdam, NY 12303 (US); Mueller, Frank, Glenville, NY 12302 (US); Murray, Robert, Rotterdam, NY 12306 (US); Saddoughi, Seyed, Clifton Park, NY 12065 (US); Allen, Edward, Bethesda, MD 20814 (US)
(74) Representative: Wardle, Callum Tarn

(57) **Abstract**

A high gain pulse generator includes a piezoelectric transformer (12) that is driven by an input power stage (14) to drive the piezoelectric transformer (12) at a desired piezoelectric transformer resonant frequency such that at least one piezoelectric transformer characteristic substantially matches at least one non-linear load characteristic such as, without limitation, a plasma load characteristic to deliver a desired pulse to the non-linear load.

## Description

### BACKGROUND

The invention relates generally to plasma generators and more particularly to a high gain miniature plasma generator power supply for use in plasma actuators for flow control, plasma assisted combustion and pulse detonation engines.

High voltage gain with high power density and low profile dimensions required by certain plasma assisted applications poses challenges for conventional power supply designs. Conventional power supply designs generally employ electromagnetic transformers for achieving a high voltage gain. Such power supply designs are expensive to produce and suffer in reliability due to internal heat build-up during high pulse repetition rate generation. These conventional power supply designs also undesirably require significant real estate, generally have low electric efficiency, and often introduce unwanted electromagnetic noise. Further, conventional electromagnetic transformer technology is not particularly suitable for many applications requiring flexibility with optimizing sizes, shapes, resonant frequencies and power throughput for the different applications, among other things.

It would be both advantageous and beneficial to provide a plasma generator power supply that overcomes the above-described limitations.

### BRIEF DESCRIPTION

Briefly, in accordance with one embodiment of the invention, a pulse generator comprises:
a piezoelectric transformer; and
a power stage configured to drive the piezoelectric transformer at a desired piezoelectric transformer resonant frequency such that the piezoelectric transformer achieves a desired high voltage transformation ratio to deliver a corresponding high voltage pulse to a non-linear load.

According to another embodiment of the invention, a pulse generator comprises:
a piezoelectric transformer; and
a solid-state resonant inverter configured to drive the piezoelectric transformer at a desired piezoelectric transformer resonant frequency such that the piezoelectric transformer delivers a corresponding high voltage pulse to a non-linear load.

According to yet another embodiment of the invention, a pulse generator comprises:
a piezoelectric transformer; and
a power stage configured to drive the piezoelectric transformer such that at least one piezoelectric transformer characteristic substantially matches at least one non-linear load characteristic.

### DRAWINGS

These and other features, aspects, and advantages of the present invention will become better understood when the following detailed description is read with reference to the accompanying drawings in which like characters represent like parts throughout the drawings, wherein:

Figure 1 is a simplified system block diagram illustrating a high gain plasma generator, according to one embodiment of the invention;

Figure 2 is a circuit diagram illustrating the power stage shown in Figure 1 in greater detail, according to one embodiment of the invention;

Figure 3 is a circuit diagram illustrating the power stage shown in Figure 1 in greater detail, according to another embodiment of the invention;

Figure 4 is a circuit diagram illustrating the power stage shown in Figure 1 in greater detail, according to yet another embodiment of the invention; and

Figure 5 is a circuit diagram illustrating the power stage shown in Figure 1 in greater detail, according to still another embodiment of the invention.

While the above-identified drawing figures set forth alternative embodiments, other embodiments of the present invention are also contemplated, as noted in the discussion. In all cases, this disclosure presents illustrated embodiments of the present invention by way of representation and not limitation. Numerous other modifications and embodiments can be devised by those skilled in the art which fall within the scope and spirit of the principles of this invention.

### DETAILED DESCRIPTION

Plasma actuators for flow control, plasma assisted combustion, and pulse detonation engines, among others, are all applications that may benefit from a plasma generator that achieves a high voltage gain with the advantages of compact size, light weight, high efficiency, less electromagnetic noise, non-flammability, and design flexibility that is not achievable using conventional electromagnetic transformers to achieve a high voltage gain.

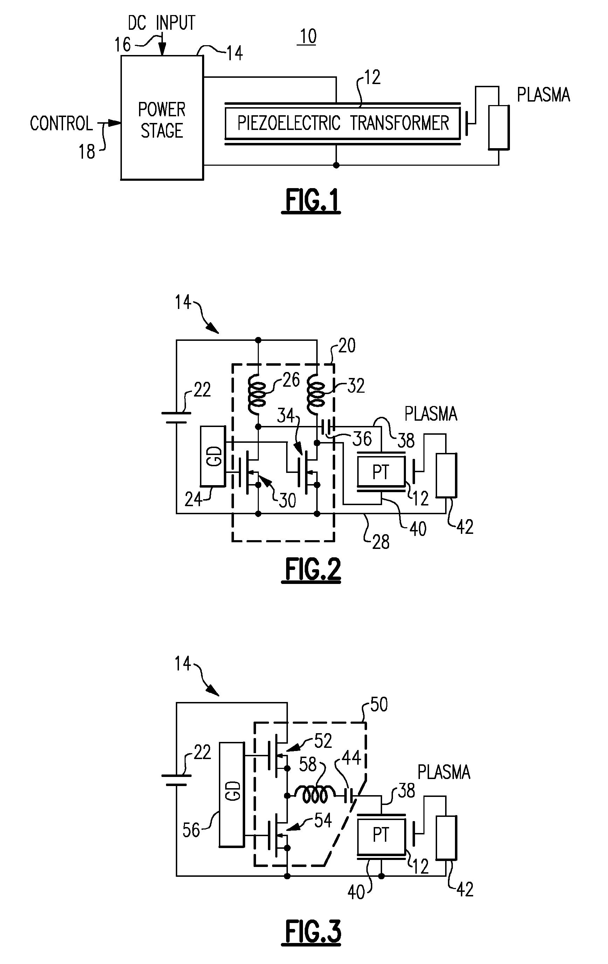

Figure 1 is a simplified system block diagram illustrating a high gain plasma generator 10, according to one embodiment of the invention. Plasma generator 10 includes a piezoelectric transformer 12 that is driven via a transformer input power stage 14. According to one aspect of the invention, power input stage 14 includes a DC input 16 and a control input 18. The DC input 16 may be, for example, provided by a battery such as depicted in Figures 2-4; while the control input 18, may be, for example, provided by an inverter such as depicted in Figures 2-4.

Piezoelectric transformers are usually made of piezo-ceramic materials such as Pb(Zr.Ti)03 (PZT) and consist of input and output parts which are mechanically connected to one another. Piezoelectric transformers are solid resonators that operate effectively at specific resonance frequencies. Extremely high voltage transformation ratios can be achieved by driving piezoelectric transformers at their resonance frequencies. The present inventors recognized that advancements in ceramic technology enables creation of smaller and finer structures while providing flexibility to optimize sizes, shapes, resonant frequencies and power throughput for different applications. Smaller size, higher efficiency, and less electromagnetic noise may be achieved for systems using piezoelectric transformers than systems using electromagnetic transformers for the same level of transferred power systems.

High gain plasma generator 10 is particularly useful in applications requiring high power density, high conversion gain, high efficiency and flexibility in design. Particular plasma generator 10 embodiments have been demonstrated to achieve a voltage conversion gain of over 200 to generate a 10mm DBD discharge with only a 3.7V input voltage. The present inventors recognized that flexible characteristics of piezoelectric transformers may be used to create plasma discharges for use in flow control, plasma aided combustion, and pulse detonation engines, among other applications.

Figure 2 is a circuit diagram illustrating the power stage 14 shown in Figure 1 in greater detail, according to one embodiment of the invention. Power stage 14 according to one aspect of the invention comprises a solid-state resonant inverter system 20. Inverter system 20 power is provided via a DC power source such as, without limitation, battery 22 that may be, for example, a 3.7V battery. A gate drive system 24 provides the desired switching mechanism to operate the inverter system 20 such that inverter system 20 generates a desired input signal to the piezoelectric transformer 12. Gate drive techniques are well known and documented in the literature, and so further details of gate drive systems and techniques are not described in further detail to preserve brevity and enhance clarity in understanding the principles and embodiments described herein.

With continued reference to Figure 2, inverter system 20 includes a first coil 26 that has one end connected to the battery 22 plus voltage and has its opposite end connected to a first input terminal 38 of piezoelectric transformer 12 via a matching capacitor 36 and also to a common ground 28 via a first switching device 30. Inverter system 20 further includes a second coil 32 that has one end connected to the battery 22 plus voltage and has its opposite end connected a second input terminal of piezoelectric transformer 12 and also to the common ground 28 via a second switching device 34. Operation of the gate drive system 24 causes the switching devices 30, 34 to turn on and off in a fashion such that an AC type input voltage is developed across the piezoelectric transformer 12 input terminals 38, 40 via the switched coils 26, 32 to achieve a voltage conversion gain that may be over 200 with only a 3.7V battery 22 voltage. The resultant voltage pulse(s) appearing at the piezoelectric transformer 12 output terminals may be sufficient in some applications to generate a 10mm dielectric barrier discharge (DBD) with only a 3.7V input voltage. A DBD plasma generator 42 may in some embodiments, comprise a tube and shell heat exchanger. DBD is synonymously known as a silent discharge or non-thermal plasma discharge. In such a plasma generator, a high voltage electrode is centered within a ground tube creating an annulus or air gap between the electrode and ground tube. When the electrodes are energized, a barrier discharge is generated by the application of a voltage potential between a high voltage source through at least one dielectric barrier, including the air gap to the ground tube that is at ground potential.

The present inventors recognized the features of piezoelectric transformers may advantageously be employed to drive a plasma load or other non-linear type load with piezoelectric transformers. They recognized that for a given input source (such as, without limitation, a voltage source), piezoelectric transformer, and non-linear load, the techniques described herein may be employed to match the piezoelectric transformer(s) to particular plasma applications/non-linear loads to achieve advantages not achievable using conventional power supply designs that generally employ electromagnetic transformers for achieving a high voltage gain. The advantages are many, and include without limitation, high voltage gains in combination with one or more of compact size, light weight, high efficiency, less electromagnetic noise, non-flammable, and design flexibility. The design flexibility provides for optimization regarding sizes, shapes, resonant frequencies and power throughput, among other things, for different applications.

Looking now at Figure 3, a circuit diagram illustrates the power stage 14 shown in Figure 1 in greater detail, according to another embodiment of the invention. Power stage 14 now comprises a solid-state resonant inverter system 50 including first and second switching devices 52, 54 and a single output coil 58. Inverter system 50 power is provided via a DC power source such as, without limitation, battery 22 that may be, for example, a 3.7V battery. A gate drive system 56 provides the desired switching mechanism to operate the inverter system 50 such that inverter system 50 generates a desired input signal to the piezoelectric transformer 12. Gate drive techniques are well known and documented in the literature, and so further details of gate drive systems and techniques are not described in further detail to preserve brevity and enhance clarity in understanding the principles and embodiments described herein.

With continued reference to Figure 3, inverter system 50 includes a single coil 58 that has one end connected to the inverter system 50 output, and has its opposite end connected to a first input terminal 38 of piezoelectric transformer 12 via a matching capacitor 44. Operation of the gate drive system 50 causes the switching devices 52, 54 to alternately turn on and off in a fashion such that an AC type input voltage is developed across the piezoelectric transformer 12 input terminals 38, 40 via the switched coil 58 to achieve a voltage conversion gain that may be over 200 with only a 3.7V battery 22 voltage, such as stated above. The resultant voltage pulse(s) appearing at the piezoelectric transformer 12 output terminals may be sufficient in some applications to generate a 10mm dielectric barrier discharge (DBD) with only a 3.7V input voltage, as also stated above.

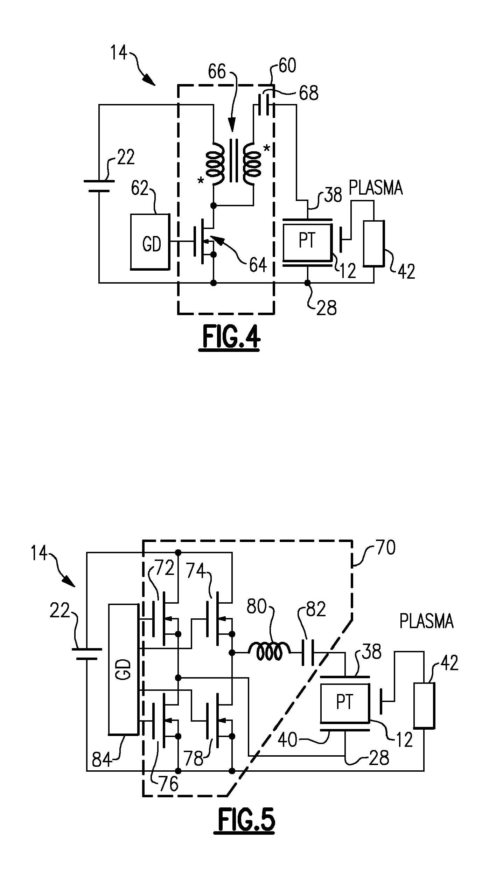

Figure 4 is a circuit diagram illustrating the power stage 14 shown in Figure 1 in greater detail, according to yet another embodiment of the invention. Power stage 14 now comprises a solid-state resonant inverter system 60 including a switching device 64 and an output transformer 66. Inverter system 60 power is provided via a DC power source such as, without limitation, battery 22 that may be, for example, a 3.7V battery. A gate drive system 62 provides the desired switching mechanism to operate the inverter system 60 such that inverter system 60 generates a desired input signal to the piezoelectric transformer 12. Gate drive techniques are well known and documented in the literature as stated above, and so further details of gate drive systems and techniques are not described in further detail to preserve brevity and enhance clarity in understanding the principles and embodiments described herein.

With continued reference to Figure 4, inverter system 60 includes a transformer that has one of its input terminals connected to the battery 22 plus voltage and has its other input terminal selectively connected to a common ground via the switching device 64. The transformer output terminals are connected to a first input terminal 38 of piezoelectric transformer 12 via a matching capacitor 68 and also selectively connected to the common ground 28 via the switching device 64. Operation of the gate drive system 62 causes the switching device 64 to turn on and off in a fashion such that an AC type input voltage is developed across the piezoelectric transformer 12 input terminals 38, 40 via the switched transformer 66 coils to achieve a voltage conversion gain that may be over 200 with only a 3.7V battery 22 voltage, as stated above. The resultant voltage pulse(s) appearing at the piezoelectric transformer 12 output terminals may be sufficient in some applications to generate a 10mm dielectric barrier discharge (DBD) with only a 3.7V input voltage, also stated above.

Figure 5 is a circuit diagram illustrating the power stage 14 shown in Figure 1 in greater detail, according to still another embodiment of the invention. Power stage 14 now comprises a solid-state resonant inverter system 70 that includes switching devices 72, 74, 76 and 78 and a resonant circuit comprising an output coil 80 in series with a capacitor 82. Those skilled in the switching circuit art will readily appreciate that many other resonant circuit configurations may just as easily be employed to implement a solid-state resonant inverter system according to the principles described herein. Solid-state resonant inverter system 70 power is provided via a DC power source such as, without limitation, battery 22 that may be, for example, a 3.7V battery. A gate drive system 84 provides the desired switching mechanism to operate the inverter system 70 such that inverter system 70 generates a desired input signal to the piezoelectric transformer 12. Gate drive techniques are well known and documented in the literature as stated above, and so further details of gate drive systems and techniques are not described in further detail to preserve brevity and enhance clarity in understanding the principles and embodiments described herein.

With continued reference to Figure 5, coil 80 has one of its terminals selectively connected to the battery 22 via switching devices 74, 78 and has its other terminal connected to one plate of resonant inverter capacitor 82. The remaining capacitor plate is connected to a first input terminal 38 of piezoelectric transformer 12. The remaining piezoelectric transformer input terminal 40 is connected to the battery 22 via switching devices 72 and 76. Operation of the gate drive system 84 causes the switching devices 72, 74, 76, 78 to turn on and off in a fashion such that an AC type input voltage is developed across the piezoelectric transformer 12 input terminals 38, 40 via the switched inverter system 70 to achieve a voltage conversion gain that may be over 200 with only a 3.7V battery 22 voltage, as stated above. The resultant voltage pulse(s) appearing at the piezoelectric transformer 12 output terminals may be sufficient in some applications to generate a 10mm dielectric barrier discharge (DBD) for a DBD plasma generator 42 with only a 3.7V input voltage, also stated above.

In summary explanation, embodiments of a high gain miniature plasma generator have been described for use in plasma actuators for flow control, plasma assisted combustion and pulse detonation engines. The embodiments use a piezoelectric transformer driven by a power input stage such as, without limitation, a solid-state resonant inverter, to obtain a high voltage gain with advantages including, without limitation, compact size, light weight, high efficiency, less electromagnetic noise, non-flammable and flexible in design, as compared to known embodiments that employ conventional power supply designs using electromagnetic transformers. Advancements in ceramic technology may be combined with piezoelectric transformer designs to provide smaller and finer structures that have flexibility to optimize sizes, shapes, resonant frequencies and power throughput for different applications.

While only certain features of the invention have been illustrated and described herein, many modifications and changes will occur to those skilled in the art. It is, therefore, to be understood that the appended claims are intended to cover all such modifications and changes as fall within the true spirit of the invention.

## Claims

1. A pulse generator (10) comprising:
a piezoelectric transformer (12); and
a power stage (14) configured to drive the piezoelectric transformer (12) at a desired piezoelectric transformer resonant frequency such that the piezoelectric transformer (12) achieves a desired high voltage transformation ratio to deliver a corresponding high voltage pulse to a non-linear load.

2. The pulse generator (10) according to claim 1, wherein the power stage (14) comprises a solid-state resonant inverter.

3. The pulse generator (10) according to claim 1, wherein the non-linear load is a plasma load.

4. The pulse generator (10) according to claim 1, wherein the power stage (14) is further configured to drive the piezoelectric transformer 12 such that at least one characteristic of the piezoelectric transformer (12) substantially matches as least one characteristic of the non-linear load.

5. The pulse generator (10) according to claim 4, wherein the at least one piezoelectric transformer characteristic comprises a resonant frequency.

6. The pulse generator (10) according to claim 1, wherein the power stage (14) and piezoelectric transformer (12) together are configured as at least one of a flow control plasma generator, a combustion plasma assist generator, or a pulse detonation engine plasma assist generator.
